# EUROPEAN PATENT SPECIFICATION

(11) **EP 1 796 447 B1**
(45) Date of publication and mention of the grant of the patent: **23.02.2011**
(21) Application number: 06256089.1
(22) Date of filing: 28.11.2006
(51) Int. Cl.: H05K 7/20

(54) **System and method for electronic chassis and rack mounted electronics with an integrated subambient cooling system**
System und Verfahren für ein elektronisches Chassis, in einem Baugruppenträger montierte Elektronik mit einem integrierten Umgebungsunterdruck-Kühlsystem
Système et méthode pour un chassis électronique, électronique montée dans une baie avec un système de refroidissement intégré sousambiant

(30) Priority: 30.11.2005 US 291041
(43) Date of publication of application: 13.06.2007
(73) Proprietor: Raytheon Company, Waltham, Massachusetts 02451-1449 (US)
(72) Inventor: Weber, Richard Martin, Prosper Texas 75078 (US); Rummel, Kerrin A., Richardson, Texas 75080 (US); Payton, Albert P., Sachse, Texas 78048 (US); Wyatt, William G., Plano, Texas 75025 (US)
(74) Representative: Lawrence, John

(56) References cited:
- EP-A- 1 380 799
- US-A- 5 761 037

## Description

### TECHNICAL FIELD OF THE INVENTION

This invention relates generally to the field of cooling systems and, more particularly, to a system and method for electronic chassis and rack mounted electronics with an integrated subambient cooling system.

### BACKGROUND OF THE INVENTION

Chassis mounted electronics continue to generate higher and higher levels of heat or thermal energy. With the generation of such thermal energy, such chassis mounted electronics need to be cooled to present overheating. However, conventional cooling systems do not always meet the current or future needs for such chassis based systems. Examples of prior techniques for cooling electronics can be found in EP 1380799 and US 5761037.

### SUMMARY OF THE INVENTION

According to one embodiment of the invention, a cooling system for a heat-generating structure that is disposed in an environment having an ambient pressure includes a channel comprising a chamber in thermal communication with the heat generating structure. The chamber has an inlet port and an exit port. The inlet port is operable to receive fluid coolant into the chamber substantially in the form of a liquid. The exit port is operable to dispense of fluid coolant out of the chamber substantially in the form of a vapor. A vapor passage of the channel is in fluid communication with the exit port. The vapor passage includes a first fluid passageway and a second fluid passageway each in fluid communication with the chamber. A device is operable to selectively close one of the first fluid passageway and the second fluid passageway according two an orientation of the chamber.

Certain embodiments of the invention may provide numerous technical advantages. For example, a technical advantage of one embodiment may include the capability to enhance cooling capability for chassis based systems. Other technical advantages of other embodiments may include the capability to enable flexibility in the integration of a cooling system with a heat generating structure or the capability to compensate for adverse orientations, including tilting, that may be experienced by a cooling system.

Although specific advantages have been enumerated above, various embodiments may include all, some, or none of the enumerated advantages. Additionally, other technical advantages may become readily apparent to one of ordinary skill in the art after review of the following figures and description.

### BRIEF DESCRIPTION OF THE DRAWINGS

For a more complete understanding of example embodiments of the present invention and its advantages, reference is now made to the following description, taken in conjunction with the accompanying drawings, in which:
FIGURE 1 is a block diagram of a cooling system, according to an embodiment of the invention; and
FIGURE 2 show an integration of a cooling system with a chassis of a circuit card assembly, according to another embodiment of the invention;
FIGURE 3 show an integration of a cooling system with a chassis of a circuit card assembly, according to another embodiment of the invention;
FIGURES 4A and 4B show an integration of a cooling system with a rack, according to another embodiment of the invention;
FIGURE 5 is a block diagram of a cooling system, according to another embodiment of the invention;
FIGURES 6A and 6B illustrate a problem that can develop in a channel;
FIGURES 7A, 7B, and 7C illustrate a channel, according to an embodiment of the invention;
FIGURE 8 is an illustration of an interior wall of cut-away channel, according to another embodiment of the invention; and
FIGURE 9 illustrates a channel, according to another embodiment of the invention.

### DETAILED DESCRIPTION OF EXAMPLE EMBODIMENTS OF THE INVENTION

It should be understood at the outset that although example embodiments of the present invention are illustrated below, the present invention may be implemented using any number of techniques, whether currently known or in existence. The present invention should in no way be limited to the example embodiments, drawings, and techniques illustrated below, including the embodiments and implementation illustrated and described herein. Additionally, the drawings are not necessarily drawn to scale.

As briefly referenced in the Background, current cooling systems do not always meet the current or future needs for chassis based systems. The teachings of certain embodiments of the invention recognize that systems that rely purely on convection or conduction cooling provide limited heat removal capability. Some air flow systems require 4°C inlet air to maintain the component temperatures limits, thereby causing undesirably large temperature gradients. Other air flow systems operating at higher temperatures (e.g., 49°C) require undesirably high air mass flow rates. Additionally, with conventional systems, there is little, if any, flexibility in the integration of the cooling system with the structure in which they are cooling. Accordingly, teachings of some embodiments of the invention recognize a cooling system that enhances cooling capability for chassis based systems. Additionally, teachings of some embodiments of the invention recognize a cooling system that enables flexibility in the integration of the cooling system with a heat generating structure.

Cooling systems may additionally be subjected to adverse orientations in adverse environments that tilt and rock the cooling systems. Accordingly, teachings of some embodiments of the invention recognize components that may be utilized in a cooling system to compensate for such adverse orientations.

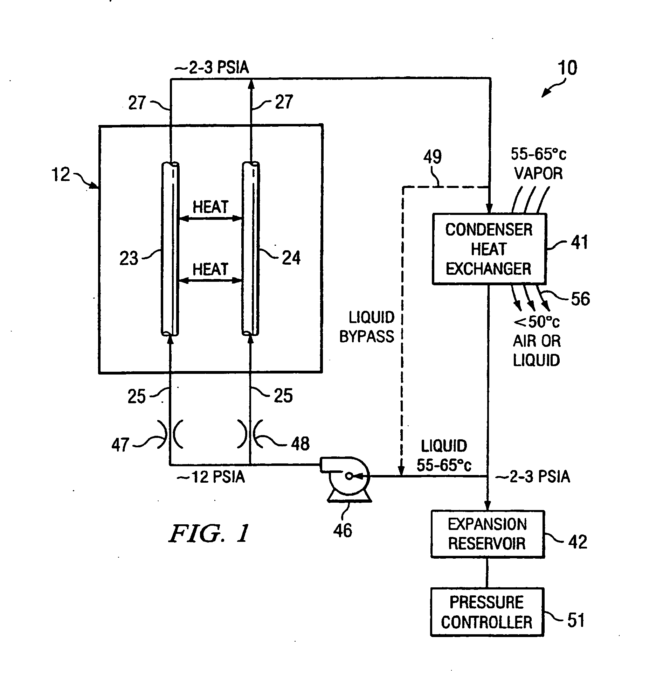

FIGURE 1 is a block diagram of a cooling system 10, according to an embodiment of the invention. In this embodiment, the cooling system 10 is shown cooling a circuit card assembly 12. Electronic or circuit components within the circuit card assembly 12 may take on a variety of configurations. Accordingly, the details of the circuit card assembly are not illustrated and described. The cooling system 10 of FIGURE 1 includes channels 23 and 24, pump 46, inlet orifices 47 and 48, a condenser heat exchanger 41, an expansion reservoir 42, and a pressure controller 51.

The circuit card assembly 12 may be arranged and designed to conduct heat or thermal energy from the electronic or circuit components on the circuit card assembly 12 to the channels 23, 24. To receive this thermal energy or heat, the channels 23, 24 may be disposed on an edge of the circuit card assembly or may extend through portions of the circuit card assembly 12, for example, through a thermal plane of circuit card assembly 12. In particular embodiments, the channels 23, 24 may extend up to the circuit components, directly receiving thermal energy from the circuit components. Although two channels 23, 24 are shown in the embodiment of FIGURE 1, one channel or more than two channels may be used to cool a circuit card assembly 12, according to other embodiments of the invention.

In operation, a fluid coolant flows through each of the channels 23, 24. As discussed later, this fluid coolant may be a two-phase fluid coolant, which enters inlet conduits 25 of channels 23, 24 in liquid form. Absorption of heat from the circuit card assembly 12 causes part or all of the liquid coolant to boil and vaporize such that some or all of the fluid coolant leaves the exit conduits 27 of channels 23, 24 in a vapor phase. To facilitate such absorption or transfer of thermal energy, the channels 23, 24 may be lined with pin fins or other similar devices which increase surface contact between the fluid coolant and walls of the channels 23, 24. Additionally, in particular embodiments, the fluid coolant may be forced or sprayed into the channels 23, 24 to ensure fluid contact between the fluid coolant and the walls of the channels 23, 24.

The fluid coolant departs the exit conduits 27 and flows through the condenser heat exchanger 41, the expansion reservoir 42, a pump 46, and a respective one of two orifices 47 and 48, in order to again to reach the inlet conduits 25 of the channels 23, 24. The pump 46 may cause the fluid coolant to circulate around the loop shown in FIGURE 1. In particular embodiments, the pump 46 may use magnetic drives so there are no shaft seals that can wear or leak with time.

The orifices 47 and 48 in particular embodiments may facilitate proper partitioning of the fluid coolant among the respective channels 23, 24 , and may also help to create a large pressure drop between the output of the pump 46 and the channels 23, 24 in which the fluid coolant vaporizes. The orifices 47 and 48 may have the same size, or may have different sizes in order to partition the coolant in a proportional manner which facilitates a desired cooling profile.

A flow 56 of fluid (either gas or liquid) may be forced to flow through the condenser heat exchanger 41, for example by a fan (not shown) or other suitable device. In particular embodiments, the flow 56 of fluid may be ambient fluid. The condenser heat exchanger 41 transfers heat from the fluid coolant to the flow 56 of ambient fluid, thereby causing any portion of the fluid coolant which is in the vapor phase to condense back into a liquid phase. In particular embodiments, a liquid bypass 49 may be provided for liquid fluid coolant that either may have exited the channels 23, 24 or that may have condensed from vapor fluid coolant during travel to the condenser heat exchanger 41.

The liquid fluid coolant exiting the condenser heat exchanger 41 may be supplied to the expansion reservoir 42. Since fluids typically take up more volume in their vapor phase than in their liquid phase, the expansion reservoir 42 may be provided in order to take up the volume of liquid fluid coolant that is displaced when some or all of the coolant in the system changes from its liquid phase to its vapor phase. The amount of the fluid coolant which is in its vapor phase can vary over time, due in part to the fact that the amount of heat or thermal energy being produced by the circuit card assembly 12 will vary over time, as the circuit card assembly 12 system operates in various operational modes.

Turning now in more detail to the fluid coolant, one highly efficient technique for removing heat from a surface is to boil and vaporize a liquid which is in contact with a surface. As the liquid vaporizes in this process, it inherently absorbs heat to effectuate such vaporization. The amount of heat that can be absorbed per unit volume of a liquid is commonly known as the latent heat of vaporization of the liquid. The higher the latent heat of vaporization, the larger the amount of heat that can be absorbed per unit volume of liquid being vaporized.

The fluid coolant used in the embodiment of FIGURE 1 may include, but is not limited to mixtures of antifreeze and water. In particular embodiments, the antifreeze may be ethylene glycol, propylene glycol, methanol, or other suitable antifreeze. In other embodiments, the mixture may also include fluoroinert. In particular embodiments, the fluid coolant may absorb a substantial amount of heat as it vaporizes, and thus may have a very high latent heat of vaporization.

Water boils at a temperature of approximately 100ºC at an atmospheric pressure of 14.7 pounds per square inch absolute (psia). In particular embodiments, the fluid coolant's boiling temperature may be reduced to between 55-65ºC by subjecting the fluid coolant to a subambient pressure of about 2-3 psia. Thus, in the embodiment of FIGURE 1, the orifices 47 and 48 may permit the pressure of the fluid coolant downstream from them to be substantially less than the fluid coolant pressure between the pump 46 and the orifices 47 and 48, which in this embodiment is shown as approximately 12 psia. The pressure controller 51 maintains the coolant at a pressure of approximately 2-3 psia along the portion of the loop which extends from the orifices 47 and 48 to the pump 46, in particular through the channels 23 and 24, the condenser heat exchanger 41, and the expansion reservoir 42. In particular embodiments, a metal bellows may be used in the expansion reservoir 42, connected to the loop using brazed joints. In particular embodiments, the pressure controller 51 may control loop pressure by using a motor driven linear actuator that is part of the metal bellows of the expansion reservoir 42 or by using small gear pump to evacuate the loop to the desired pressure level. The fluid coolant removed may be stored in the metal bellows whose fluid connects are brazed. In other embodiments, the pressure controller 51 may utilize other suitable devices capable of controlling pressure.

In particular embodiments, the fluid coolant flowing from the pump 46 to the orifices 47 and 48 may have a temperature of approximately 55ºC to 65ºC and a pressure of approximately 12 psia as referenced above. After passing through the orifices 47 and 48, the fluid coolant may still have a temperature of approximately 55ºC to 65ºC, but may also have a lower pressure in the range about 2 psia to 3 psia. Due to this reduced pressure, some or all of the fluid coolant will boil or vaporize as it passes through and absorbs heat from the channels 23 and 24.

After exiting the exits ports 27 of the channels 23, 24, the subambient coolant vapor travels to the condenser heat exchanger 41 where heat or thermal energy can be transferred from the subambient fluid coolant to the flow 56 of fluid. The flow 56 of fluid in particular embodiments may have a temperature of less than 50ºC. In other embodiments, the flow 56 may have a temperature of less than 40ºC. As heat is removed from the fluid coolant, any portion of the fluid which is in its vapor phase will condense such that substantially all of the fluid coolant will be in liquid form when it exits the condenser heat exchanger 41. At this point, the fluid coolant may have a temperature of approximately 55ºC to 65ºC and a subambient pressure of approximately 2 psia to The fluid coolant may then flow to pump 46, which in particular embodiments 46 may increase the pressure of the fluid coolant to a value in the range of approximately 12 psia, as mentioned earlier. Prior to the pump 46, there may be a fluid connection to an expansion reservoir 42 which, when used in conjunction with the pressure controller 51, can control the pressure within the cooling loop. 3 psia.

It will be noted that the embodiment of FIGURE 1 may operate without a refrigeration system. In the context of electronic circuitry, such as may be utilized in the circuit card assembly 12, the absence of a refrigeration system can result in a significant reduction in the size, weight, and power consumption of the structure provided to cool the circuit components of the circuit card assembly 12.

Although components of one embodiment of a cooling system 10 have been shown in FIGURE 1, it should be understood that other embodiments of the cooling system 10 can include more, less, or different component parts. For example, although specific temperatures and pressures have been described for one embodiment of the cooling system, other embodiments of the cooling system 10 may operate at different pressures and temperatures. Additionally, in some embodiments a coolant fill port and/or a coolant bleed port may be utilized with metal-to-metal caps to seal them. Further, in some embodiments, all or a portion of the joints between various components may be brazed, soldered or welded using metal-to-metal seal caps.

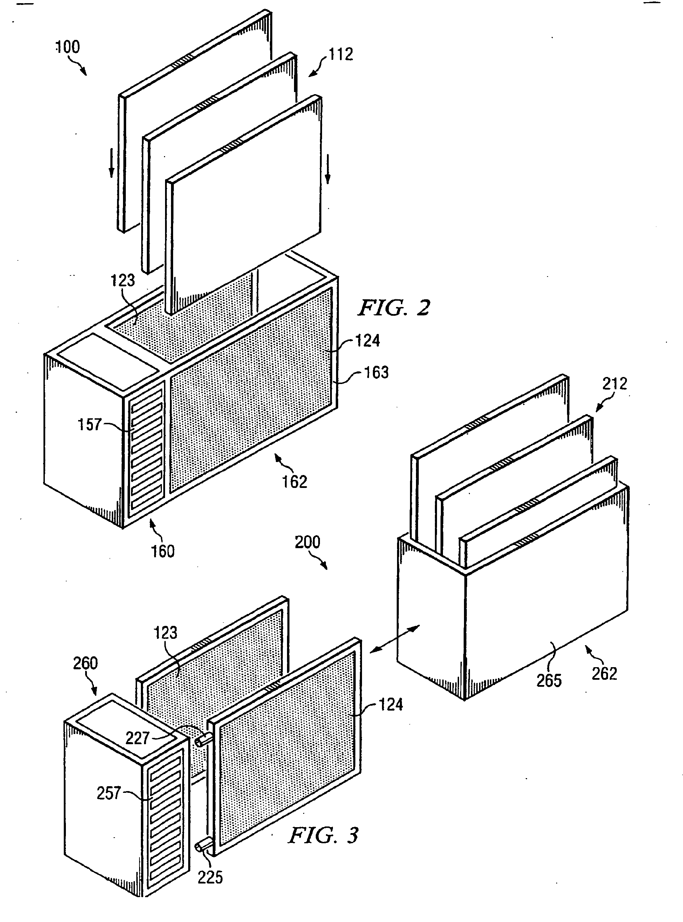

FIGURE 2 show an integration of a cooling system 100 with a chassis 162 of a circuit card assembly 112, according to another embodiment of the invention. The cooling system 100 of FIGURE 2 may utilize similar or different component parts than those outlined in the block diagram of the cooling system 10 of FIGURE 1. In this integration, components of the cooling system 100 such as, but not limited to, the condenser heat exchanger, the pump, the pressure controller, and the expansion reservoir may be disposed in an end piece 160 on one end of the chassis 162. In a manner similar to that described above with reference to FIGURE 1, the components of the end piece 160 may circulate fluid coolant through channels 123, 124 that are disposed in coldwalls 163 of the chassis 162. For example, subambient pressurized fluid coolant may enter the channels 123, 124 disposed within the coldwalls 163 in a substantially liquid state.

Thermal energy from the circuit card assembly 112 boils or vaporizes at least a portion of the subambient fluid coolant, allowing in particular embodiments a high heat flux or high heat load. The fluid coolant exits the channels 124 disposed in the coldwalls 163 in a substantially vapor state. The heat inherent within the vapor fluid coolant is then removed as the vapor fluid coolant travels through the condensing heat exchanger in the end piece 160. To facilitate this removal, the end piece 160 may include vents 157 (only one shown in FIGURE 2) for the heat exchanger (not explicitly shown. The vents 157 are operable to interact with a flow of ambient fluid for transfer of thermal energy. Upon condensing, the fluid coolant may be circulated back to the channels 123, 124.

FIGURE 3 show an integration of a cooling system 200 with a chassis 262 of a circuit card assembly 212, according to another embodiment of the invention. The integration of the cooling system 200 with the chassis 262 may be similar to that described above with reference to the embodiment of FIGURE 2, except that the chassis 262 of FIGURE 3 is removable from the cooling system 200. In this embodiment, the cooling system 200 may have similar or different features than the cooling system 100 of FIGURE 2 and the cooling system 10 of FIGURE 1. For example, the cooling system 200 of FIGURE 3 may includes channels 223, 224 and an end piece 260 with vents 257. The end piece 260, similar to end piece 160 of FIGURE 2 may include, but is not limited to, a heat exchanger, a pump, a pressure controller, and an expansion reservoir. The inlet conduit 225 and exit conduit 227 for the cooling system 200 can also be seen.

The chassis 262 includes an inner chassis wall 265, which can be coupled to the channels 223, 224 in a variety of manners, including, but not limited to, bolting, clamping, or use of a variety of actuating devices. Thermal energy or heat may be conducted from components of the circuit card assembly 212 to the inner chassis wall 265 to the channels 223, 224. From the channels 223, 224, the thermal energy or heat may be transferred through the remaining portion of the cooling system 200 in a similar manner to that described above with reference to FIGURE 2, namely through vaporization in the channels 223, 224 and then offloading to a flow of ambient fluid in the condensing heat exchanger in the end piece 260, for example, through use of the vent 257.

With the embodiment of FIGURE 3, the circuit card assembly 212 and chassis 262 can be can be removed and replaced without disrupting or disassembling the sealed cooling system 200. Although the channels 223, 224 have been described as coupling to an inner chassis wall 265 in this embodiment, in other embodiments the cooling system may be used to circulate flow directly to the circuit card assembly 212. In such an embodiment, components of the circuit card assembly 212 may be attached to a hollow thermal plane, which may include any of a variety of features to direct flow or improve heat transfer. In this embodiment, the fluid coolant may enter the hollow thermal plane in a liquid state and vaporize within the thermal plane. Such an embodiment may provide high heat transfer at substantially low fluid flow rates.

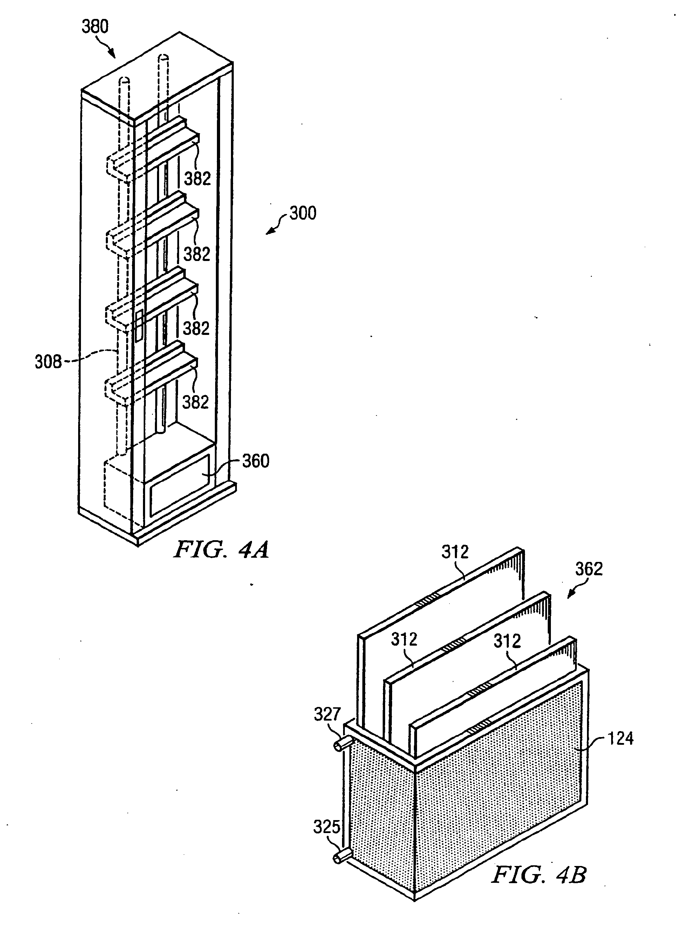

FIGURES 4A and 4B show an integration of a cooling system 300 with a rack 380, according to another embodiment of the invention. The rack 380 may be designed to hold a plurality of circuit card assemblies 312 and their associated chassis using shelves 382 or other suitable components.

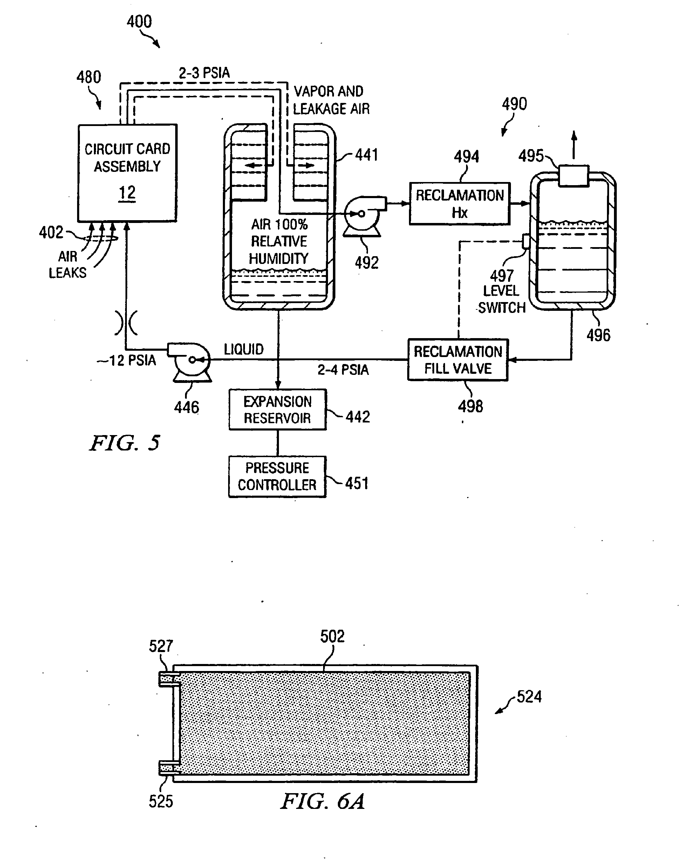

Similar to the embodiments of FIGURES 2 and 3, portions of the cooling system 300 may be may be disposed in an end piece 360 on an end of the rack 380. The end piece 360 may include, but is not limited to, a heat exchanger, a pump, a pressure controller, and a expansion reservoir. Further details of other components that may be used with a cooling system 300 are described below in FIGURE 5 with reference to another cooling system 400.

The cooling system 300 of FIGURES 4A and 4B includes a coolant manifold 308, which may deliver liquid coolant (e.g., received from the end piece 360) and receive vapor coolant (e.g, for delivery to the end piece 360). To deliver such liquid coolant and receive vapor coolant, the coolant manifold 308 may be arranged in a variety of configurations. In particular embodiments, the coolant manifold 308 may be vertically disposed in a rear portion of the rack 380.

One or more electronic chassis 362 may respectively be plugged into the manifold 308 to obtain cooling functionality. The chassis 362 may have a fluid channel 324 in its wall, which contain an inlet port 325 (e.g., for substantial liquid fluid coolant) and an exit port 327 (e.g., for substantially vapor fluid coolant). The inlet port 325 and the exit port 327 of the electronic chassis 362 may respectively be fluidly coupled to the manifold 308 using a variety of fluid coupling techniques, including but not limited to techniques which utilize seals, O-rings, and other devices.

In this embodiment, each chassis 362 may utilize the centralized cooling system 300 without having its own separate cooling system.

Although the chassis 362 has been described as fluidly coupling to a coolant manifold 308 in the rack 380 in this embodiment, in other embodiments, the rack 380 may provide a series of coolant channels plumbed into the walls of the rack 380. Accordingly, each chassis 362 would simply slide into its allocated slot where it may be coupled or clamped to the coolant channels in a manner similar to that described above with reference to FIGURE 3. An advantage of such an embodiment is that the cooling system may be sealed. Accordingly, minimized perturbances to such a sealed system would occur during insertion or removal of a chassis 362.

FIGURE 5 is a block diagram of a cooling system 400, according to another embodiment of the invention. The cooling system 400 of FIGURE 5 may operate in a similar to the cooling system 10 of FIGURE 1; however, the cooling system 400 of FIGURE 5 also incorporates an air removal system 490. For a variety of reasons, unintended air or other fluids may be introduced into the cooling system 400. For example, with reference to FIGURE 4, the insertion of the inlet port 325 and the exit port 327 into the coolant manifold 308 may undesirably insert air or air may undesirably leak into the system, for example, through O-ring connections used in a fluid coupling between the inlet port 325 and the manifold 380 or the exit port 327. Accordingly the cooling system 400 utilize the air removal system 490 to remove air from the cooling system 400. The air removal system 490 in the embodiment of FIGURE 5 includes an air pump 492, a reclamation heat exchanger 494, an air trap 496, and a reclamation fill valve 498.

With reference to FIGURE 5, the cooling loop for the cooling system 400 is similar to cooling loop for the cooling system 10 of FIGURE 1 for example, including a pump 460, an expansion reservoir 442, a pressure controller 451, and a condenser heat exchanger 441. However, air leaks 402 may enter the system at a rack 480 and travel to the condenser heat exchanger 441. At the condenser heat exchanger 441, condensed coolant liquid may pass though while air (and any associated coolant vapor that may be present therein) may be pumped using air pump 492 to a reclamation heat exchanger 494. The reclamation heat exchanger 494 may cool the air / coolant vapor combination, which condenses the vapor from the air stream being removed from the bottom of the condenser heat exchanger 441. Coolant separates from the air in a trap 496 while the air exits through a vent 495. A level switch 497 may be in communication with a reclamation fill valve 498 to allow the reclamation fill valve 498 to open when recovered coolant is present. The recovered coolant may be reintroduced to the loop through the reclamation fill valve 498 and a conduit in communication with the pump 446. Although one example of an air removal system 490 has been shown with reference to FIGURE 5, other air removal systems may be used in other embodiments of the invention with more, less, or alternative component parts.

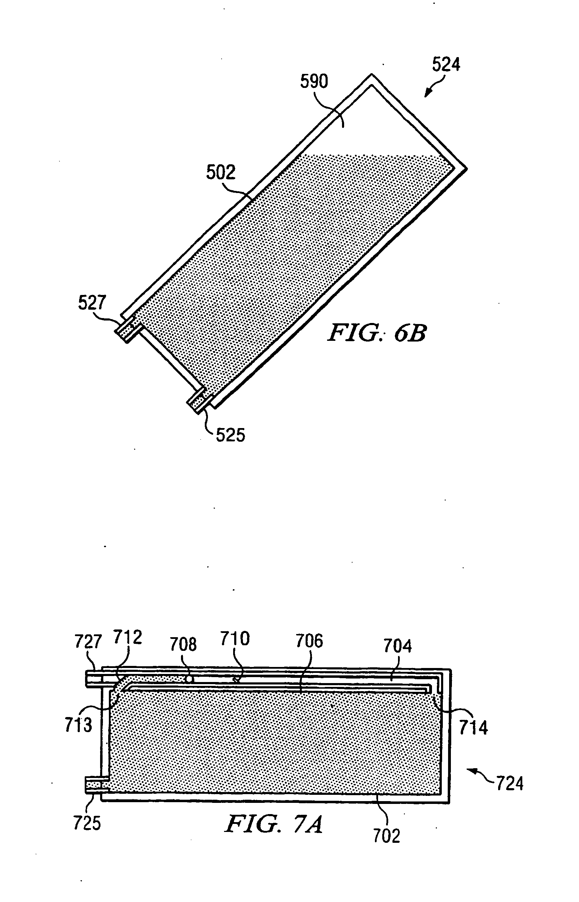

FIGURES 6A and 6B illustrate a problem that can develop in a channel 524. In particular embodiments, the channel 524 may be positioned adjacent a chassis that is subjected to movement. For example, the chassis and channel 524 may be subjected to as much as plus or minus 60° rolling and pitching in a combat vehicle. In particular embodiments, it is desirable for the interior of the wall of the channel 524 to be wet, for example, to ensure appropriate heat transfer. Accordingly, a chamber 502 of the channel 524 may be substantially filled with liquid fluid coolant. Vapor that develops during boiling heat transfer needs to be allowed to exit the channel 524, for example, through a an exit port 527. However, during such rolling and pitching, an undesirable vapor pocket 590 can arise as shown in FIGURE 6B. When such a vapor pocket 590 develops, vapor does not exit through the exit port 527.

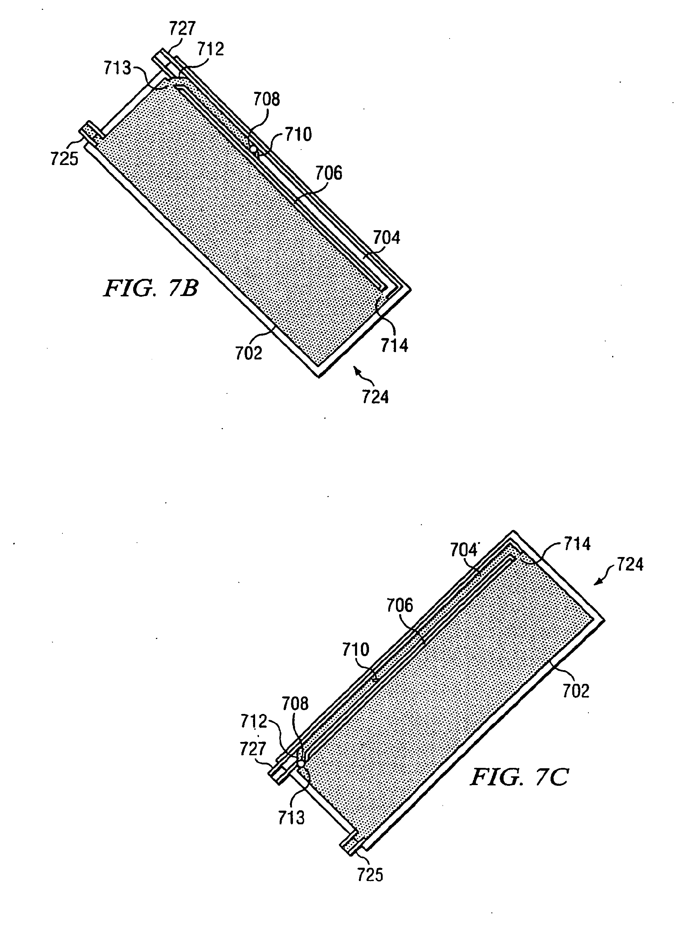

FIGURES 7A, 7B, and 7C illustrate a channel 724, according to an embodiment of the invention. Given the problem with the development of vapor pockets, the configuration of the channel 724 of FIGURES 7A, 7B, and 7C minimizes development of vapor pockets. The channel 724 includes a coolant chamber 702, a vapor passage 704, a rib 706, a check ball 708, a ball stop 710, a ball seat 712, an inlet port 725, and an exit port 727.

When the channel 724 is level as shown in FIGURE 7A, vapor can exit from either of the passageways 713, 714 in the upper corners of the chamber 702. When the channel 724 is tilted with the exit port 727 upward, the check ball 708 rests on the ball stop 710 as shown in FIGURE 7B. In FIGURE 7B, the vapor will exit from the passageway 713 adjacent the ball seat 712 as the check ball 708 does not block passageway 713. When the channel 724 is tilted with the exit port 727 downward, the check ball 708 rests on the ball seat 712 as shown in FIGURE 7C. In this case, the check ball 708 closes the passageway 713, which forces the vapor to exit through passageway 714.

In the embodiment of FIGURES 7A, 7B, and 7C, the fluid coolant remains in contact with the wall of the chamber 702 which, for example, may be lined with pin fins. Accordingly, proper heat transfer may occur while still allowing vapor to exit the exit port 727.

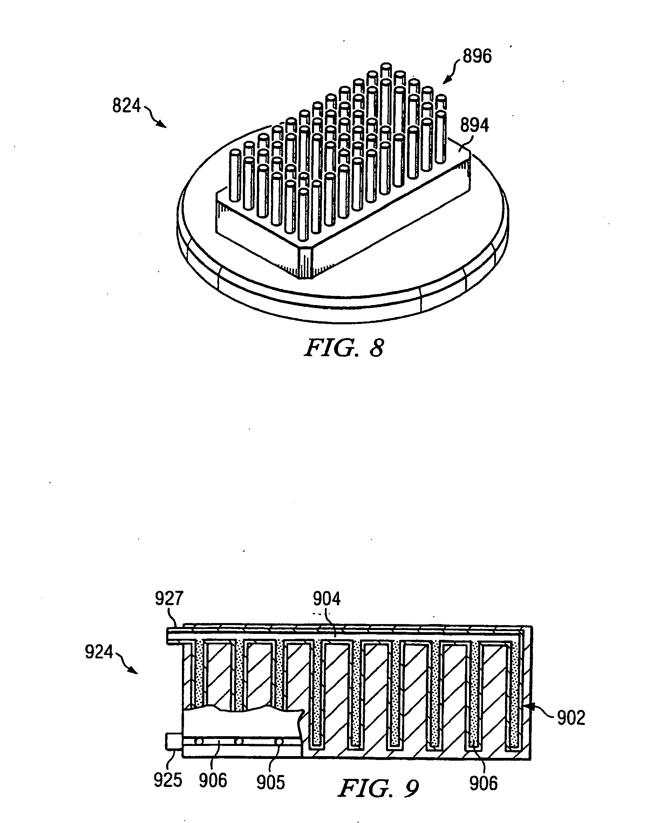

FIGURE 8 is an illustration of an interior wall 894 of cut-away channel 824, according to another embodiment of the invention. The embodiment of FIGURE 8 minimizes development of vapor pockets by using internal jet impingement. The interior wall 894 of the channel 824 includes a plurality of pin fins 896 extending therefrom. With internal jet impingement, coolant jets with small nozzles (not expressly shown) direct coolant on to the plurality of pin fins 896. The liquid fluid vaporizes upon contact with the pins fins 896. Accordingly, liquid fluid coolant is not free standing and vapor pockets do not develop. In operation, the plurality of pin fins 896 may linearly be aligned in clusters or strips that coincide with a location where heat transfer is expected to occur, for example, an edge of the circuit card assembly.

FIGURE 9 illustrates a channel 924, according to another embodiment of the invention. For purposes of illustration, portions of the channel 924 are shown in a cut-way view. The channel 924 of FIGURE 9 includes a plurality of walled areas or passages 902 connected by a common vapor passage 904. Each of the passages 902 may be fed liquid coolant through a coolant feed hole 905. In particular embodiments, each of the passages 902 may be lined with pin fins 906. The pin fins 906 may couple to a plane of thermal transfer and extend outwards across each passage 902 to increase surface area in the thermal transfer. Each of the coolant feed holes 905 may be connected through a common feed passage 906, which receives the liquid coolant from an inlet conduit 925.

In particular embodiments, the feed passage 906 may be disposed in a separate sheet of material within the channel 924. For example, the passages 902 may be directly adjacent the plane of thermal transfer while the feed passage 906 is at least one layer removed from the plane of thermal transfer. Controlled liquid coolant may be forced into the bottom of each respective feed hole 905 up through passages 902 transversing the plurality of pin fins 906. As the liquid fluid coolant boils to a vapor state, the vapor in each passage 902 will move up to the common vapor passage 904. If the channel 924 is tilted, liquid coolant may run out of one of the passages 902, cascading over another passage 902. However, vapor may still escape to the common vapor passage 904 and out an exit port 927. Each one of the passages 902 may correspond to a board for a circuit card assembly or another location where heat may be expected.

Although the present invention has been described with several embodiments, a myriad of changes, variations, alterations, transformations, and modifications may be suggested to one skilled in the art, and it is intended that the present invention encompass such changes, variations, alterations, transformation, and modifications as they fall within the scope of the appended claims.

## Claims

1. A cooling system (10) for a heat-generating structure (12) disposed in an environment having an ambient pressure the cooling system (10) including a channel (724) comprising:
a chamber (702) in thermal communication with the heat generating structure (12), the chamber (702) having on inlet port (725) and an exit port (727), the inlet port (725) operable to receive fluid coolant into the chamber (702) substantially in the form of a liquid, and the exit port (727) operable to dispense of fluid coolant out of the chamber (702) substantially in the form of a vapor;
a structure within the chamber (702) which inhibits blockage of the exit port (727) when the chamber (702) is subjected to adverse orientations including
a vapor passage (704) in fluid communication with the exit port (727), the vapor passage (704) including a first fluid passageway (713) and a second fluid passageway (714) each in fluid communication with the chamber (702); and
a device (708) operable to selectively close one of the first fluid passageway (713) and the second fluid passageway (714) according to an orientation of the chamber (702), allowing thereby the vapor to exit through the other of first fluid passageway (713) and the second fluid passageway (714).

2. The cooling system (10) of Claim 1, further comprising:
a structure (47) which reduces a pressure of the fluid coolant to a subambient pressure at which the fluid coolant has a boiling temperature less than a temperature of the heat-generating structure (12).

3. The cooling system of claim 1 or Claim 2, further comprising:
a structure (46) which directs a flow of the fluid coolant in the form of a liquid into the chamber (702) through the inlet port (725), wherein heat from the heat-generating structure causes the fluid coolant in the form of a liquid to boil and vaporize in the chamber (702) so that the fluid coolant adsorbs heat from the heat-generating structure (12) as the fluid coolant change state.

4. The cooling system of any of Claims 1-3, wherein the device (708) operable to selectively close one of the fluid passageways (713, 714) is a check ball operable to roll in the vapor passageway.

5. The cooling system (10) of Claim 4, wherein the vapor passageway (704) includes a ball seat (712) to receive the check ball and close the first fluid passageway (713) when the adverse orientation of the chamber (702) places the exit port (727) in a downward position.

6. The cooling system (10) of Claim 4, wherein the vapor passageway (704) includes a ball stop (710) to receive the check ball and close the second fluid passageway (714) when the adverse orientation of the chamber (702) places the exit port (727) in an upward position.

7. The cooling system (10) of any of Claims 1-6, further comprising:
an air removal system (490) operable to remove air that leaks into the cooling system (10).

8. The cooling system (10) of any of Claims 1-7, wherein the chamber (702) comprises a plurality of passage, each of the plurality of passages in fluid communication with the vapor passage (704).

9. A method for cooling a heat-generating structure (12) disposed in an environment having an ambient pressure, the method comprising:
providing a chamber (702) in thermal communication with the heat generating structure (12), the chamber (702) having an inlet port (725) and an exit port (727), the inlet port (725) operable to receive the fluid coolant into the chamber (702) substantially in the form of a liquid, and the exit port (727) operable to dispense of fluid coolant out of the chamber (702) substantially in the form of a vapor, the chamber (702) having a structure within the chamber (702) which inhibits blockage of the exit port (727) when the chamber (702) is subjected to adverse orientations including a vapor passage (704) in fluid communication with the exit port (721), the vapor passage (704) including a first fluid passageway (713) and a second fluid passageway (714) each in fluid communication with the chamber (702), and a device (708) operable to selectively close one of the first fluid passageway (713) and the second fluid passageway (714) according to an orientation of the chamber (702);
bringing the fluid coolant into thermal communication with the heat- generating structure in the channel, the heat from the beat-generating structure causing the fluid coolant in the font ol' a liquid to boil and vaporize in the channel so that the fluid coolant absorbs heat from the heat-generating structure as the fluid coolant changes state: and
selectively closing one of the first fluid passageway (713) and the second fluid passageway (714) according to an orientation of the chamber (702) and allowing the vapor to exit through the other of first fluid passageway (713) and the second fluid passageway (714).

10. The method of Claim 9, further comprising:
reducing a pressure of the fluid coolant to a subambient pressure at which the fluid coolant has a boiling temperature less than a temperature of the heat-generating structure.

11. The method of Claim 9 or Claim 10, further comprising:
directing a flow of the fluid coolant in the form of a liquid into the chamber (702) through the inlet port (725), wherein heart from the heat-generating structure causes the fluid coolant in the form of a liquid to boil and vaporize in the chamber (702) so that the fluid coolant absorbs heat from the heat-generating structure (12) as the fluid coolant changes state.

12. The method of any of Claims 9-11, further comprising:
removing air that leaks into the chamber (702).

## Patentansprüche

1. Kühlsystem (10) für eine wärmeerzeugende Anordnung (12), die in einer einen Umgebungsdruck aufweisenden Umgebung angeordnet ist, wobei das Kühlsystem (10) einen Kanal (724) enthält, umfassend:
eine Kammer (702) in thermischer Verbindung mit der wärmeerzeugenden Anordnung (12),
wobei die Kammer (702) einen Einlassanschluss (725) und einen Ausgangsanschluss (727) aufweist,
wobei der Einlassanschluss (725) betreibbar ist, um ein Fluidkühlmittel in der Kammer (702) im Wesentlichen in Form einer Flüssigkeit aufzunehmen,
und wobei der Auslassanschluss (727) betreibbar ist, um das Fluidkühlmittel aus der Kammer (702) im Wesentlichen in Form eines Dampfes abzugeben;
eine in der Kammer (702) vorgesehene Anordnung bzw. Struktur, die ein Blockieren des Auslassanschlusses (727) verhindert, wenn die Kammer (702) ungünstigen Ausrichtungen ausgesetzt ist, enthaltend einen Dampfdurchgang (704) in Fluidverbindung mit dem Auslassanschluss (727),
wobei der Dampfdurchgang (704) einen ersten Fluiddurchgang (713) und einen zweiten Fluiddurchgang (714) jeweils in Fluidverbindung mit der Kammer (702) enthält;
und eine Vorrichtung (708), die betreibbar ist zum selektiven Schließen eines der den ersten Fluiddurchgang (713) und den zweiten Fluiddurchgang (714) umfassenden Fluiddurchgänge entsprechend einer Ausrichtung der Kammer (702), um dadurch ein Austreten des Dampfes durch den anderen der den ersten Fluiddurchgang (713) und den zweiten Fluiddurchgang (714) umfassenden Fluiddurchgänge zuzulassen.

2. Kühlsystem (10) nach Anspruch 1, ferner umfassend:
eine Anordnung (47), die einen Druck des Fluidkühlmittels auf einen Unterumgebungsdruck verringert, bei dem das Fluidkühlmittel eine Siedetemperatur besitzt, die niedriger ist als eine Temperatur der wärmeerzeugenden Anordnung (12).

3. Kühlsystem nach Anspruch 1 oder 2, ferner umfassend:
eine Anordnung (46), die einen Strom des Fluidkühlmittels in Form einer Flüssigkeit durch den Einlassanschluss (725) in die Kammer (702) leitet,
wobei Wärme von der wärmeerzeugenden Anordnung bewirkt, dass das Fluidkühlmittel in der Kammer (702)in Form einer Flüssigkeit siedet und verdampft,
so dass das Fluidkühlmittel Wärme von der wärmeerzeugenden Anordnung (12) absorbiert, wenn das Fluidkühlmittel den Zustand ändert.

4. Kühlsystem nach einem der Ansprüche 1 bis 3, wobei die Vorrichtung (708), die betreibbar ist, um einen der Fluiddurchgänge (713, 714) selektiv zu schließen, eine Absperrkugel ist, die betreibbar ist, um in dem Dampfdurchgang zu rollen.

5. Kühlsystem (10) nach Anspruch 4, wobei der Dampfdurchgang (704) einen Kugelsitz (712) enthält, um die Absperrkugel aufzunehmen und den ersten Fluiddurchgang (713) zu schließen, wenn die ungünstige Ausrichtung der Kammer (702) den Auslassanschluss (727) in eine Abwärtsposition bringt.

6. Kühlsystem (10) nach Anspruch 4, wobei der Dampfdurchgang (704) ein Kugelstoppglied (710) enthält, um die Absperrkugel aufzunehmen und den zweiten Fluiddurchgang (714) zu schließen, wenn die ungünstige Ausrichtung der Kammer (702) den Auslassanschluss (727) in eine Aufwärtsposition bringt.

7. Kühlsystem (10) nach einem der Ansprüche 1 bis 6, ferner umfassend ein Luftabführsystem (490), welches betreibbar ist, um Luft abzuführen, die in das Kühlsystem (10) eindringt.

8. Kühlsystem (10) nach einem der Ansprüche 1 bis 7, wobei die Kammer (702) eine Mehrzahl von Durchgängen aufweist, deren jeder mit dem Dampfdurchgang (704) in Fluidverbindung ist.

9. Verfahren zum Kühlen einer wärmeerzeugenden Anordnung (12), die in einer einen Umgebungsdruck aufweisenden Umgebung angeordnet ist, umfassend:
Bereitstellen einer Kammer (702) in thermischer Verbindung mit der wärmeerzeugenden Anordnung (12),
wobei die Kammer (702) einen Einlassanschluss (725) und einen Auslassanschluss (727) aufweist,
wobei der Einlassanschluss (725) betreibbar ist, um das Fluidkühlmittel in der Kammer (702) im Wesentlichen in Form einer Flüssigkeit aufzunehmen,
und wobei der Auslassanschluss (727) betreibbar ist, um das Fluidkühlmittel aus der Kammer (702) im Wesentlichen in Form eines Dampfes abzugeben,
wobei die Kammer (702) eine innerhalb der Kammer (702) vorgesehene Anordnung bzw. Struktur aufweist, die ein Blockieren des Auslassanschlusses (727) verhindert,
wenn die Kammer (702) ungünstigen Ausrichtungen ausgesetzt ist, enthaltend einen Dampfdurchgang (704) in Fluidverbindung mit dem Auslassanschluss (727),
wobei der Dampfdurchgang (704) einen ersten Fluiddurchgang (713) und einen zweiten Fluiddurchgang (714) jeweils in Fluidverbindung mit der Kammer (702) aufweist,
und eine Vorrichtung (708), die betreibbar ist, um einen der den ersten Fluiddurchgang (713) und den zweiten Fluiddurchgang (714) umfassenden Fluiddurchgänge entsprechend einer Ausrichtung der Kammer (702) selektiv zu schließen;
In-thermische-Verbindung-Bringen des Fluidkühlmittels mit der wärmeerzeugenden Anordnung in dem Kanal,
wobei die Wärme von der wärmeerzeugenden Anordnung bewirkt, dass das Fluidkühlmittel in dem Kanal in Form einer Flüssigkeit siedet und verdampft, so dass das Fluidkühlmittel Wärme von der wärmeerzeugenden Anordnung absorbiert, wenn das Fluidkühlmittel den Zustand ändert;
und selektives Schließen eines der den ersten Fluiddurchgang (713) und den zweiten Fluiddurchgang (714) umfassenden Fluiddurchgänge entsprechend einer Ausrichtung der Kammer (702) und Zulassen des Austritts des Dampfes durch den anderen der den ersten Fluiddurchgang (713) und den zweiten Fluiddurchgang (714) umfassenden Fluiddurchgänge.

10. Verfahren nach Anspruch 9, ferner umfassend:
Verringern eines Drucks des Fluidkühlmittels auf einen Unterumgebungsdruck, bei dem das Fluidkühlmittel eine Siedetemperatur besitzt, die niedriger ist als eine Temperatur der wärmeerzeugenden Anordnung.

11. Verfahren nach Anspruch 9 oder 10, ferner umfassend:
Einleiten eines Stromes des Fluidkühlmittels in Form einer Flüssigkeit durch den Einlassanschluss (725) in die Kammer (702),
wobei Wärme von der wärmeerzeugenden Anordnung bewirkt, dass das Kühlmittel in Form einer Flüssigkeit in der Kammer (702) siedet und verdampft, so dass das Fluidkühlmittel Wärme von der wärmeerzeugenden Anordnung (12) absorbiert, wenn das Fluidkühlmittel den Zustand ändert.

12. Verfahren nach einem der Ansprüche 9 bis 11, ferner umfassend ein Abführen von Luft, die in die Kammer (702) eindringt.

## Revendications

1. Système de refroidissement (10) pour une structure générant de la chaleur (12) disposée dans un environnement ayant une pression ambiante, le système de refroidissement (10) comprenant un canal (724) comprenant :
une chambre (702) en communication thermique avec la structure générant de la chaleur (12), la chambre (702) comportant un orifice d'entrée (725) et un orifice de sortie (727), l'orifice d'entrée (725) pouvant être utilisé pour recevoir un fluide de refroidissement dans la chambre (702) sensiblement sous la forme d'un liquide, et l'orifice de sortie (727) pouvant être utilisé pour distribuer le fluide de refroidissement hors de la chambre (702) sensiblement sous la forme d'une vapeur ;
une structure dans la chambre (702) qui empêche le blocage de l'orifice de sortie (727) lorsque la chambre (702) est soumise à des orientations défavorables comprenant
un passage de vapeur (704) en communication fluidique avec l'orifice de sortie (727), le passage de vapeur (704) comprenant une première voie de passage de fluide (713) et une deuxième voie de passage de fluide (714) chacune en communication fluidique avec la chambre (702) ; et
un dispositif (708) pouvant être utilisé pour fermer de manière sélective l'une de la première voie de passage de fluide (713) et de la deuxième voie de passage de fluide (714) en fonction d'une orientation de la chambre (702), permettant de ce fait à la vapeur de sortir à travers l'autre de la première voie de passage de fluide (713) et de la deuxième voie de passage de fluide (714).

2. Système de refroidissement (10) selon la revendication 1, comprenant en outre :
une structure (47) qui réduit une pression du fluide de refroidissement à une pression sub-atmosphérique à laquelle le fluide de refroidissement a une température d'ébullition inférieure à une température de la structure générant de la chaleur (12).

3. Système de refroidissement selon la revendication 1 ou la revendication 2, comprenant en outre :
une structure (46) qui dirige un écoulement du fluide de refroidissement sous la forme d'un liquide dans la chambre (702) à travers l'orifice d'entrée (725), dans lequel la chaleur provenant de la structure générant de la chaleur amène le fluide de refroidissement sous la forme d'un liquide à bouillir et à se vaporiser dans la chambre (702) de sorte que le fluide de refroidissement absorbe la chaleur provenant de la structure générant de la chaleur (12) alors que le fluide de refroidissement change d'état.

4. Système de refroidissement selon l'une quelconque des revendications 1 à 3, dans lequel le dispositif (708) pouvant être utilisé pour fermer de manière sélective l'une des voies de passage de fluide (713, 714) consiste en une bille d'arrêt pouvant être utilisée pour rouler dans la voie de passage de vapeur.

5. Système de refroidissement (10) selon la revendication 4, dans lequel la voie de passage de vapeur (704) comprend un siège de bille (712) pour recevoir la bille d'arrêt et fermer la première voie de passage de fluide (713) lorsque l'orientation défavorable de la chambre (702) place l'orifice de sortie (727) dans une position vers le bas.

6. Système de refroidissement (10) selon la revendication 4, dans lequel la voie de passage de vapeur (704) comprend une butée de bille (710) pour recevoir la bille d'arrêt et fermer la deuxième voie de passage de fluide (714) lorsque l'orientation défavorable de la chambre (702) place l'orifice de sortie (727) dans une position vers le haut.

7. Système de refroidissement (10) selon l'une quelconque des revendications 1 à 6, comprenant en outre :
un système de retrait d'air (490) pouvant être utilisé pour retirer l'air qui s'infiltre dans le système de refroidissement (10).

8. Système de refroidissement (10) selon l'une quelconque des revendications 1 à 7, dans lequel la chambre (702) comprend une pluralité de passages, chacun de la pluralité de passages étant en communication fluidique avec le passage de vapeur (704).

9. Procédé pour refroidir une structure générant de la chaleur (12) disposée dans un environnement ayant une pression ambiante, le procédé consistant à :
prévoir une chambre (702) en communication thermique avec la structure générant de la chaleur (12), la chambre (702) comportant un orifice d'entrée (725) et un orifice de sortie (727), l'orifice d'entrée (725) pouvant être utilisé pour recevoir le fluide de refroidissement dans la chambre (702) sensiblement sous la forme d'un liquide, et l'orifice de sortie (727) pouvant être utilisé pour distribuer le fluide de refroidissement hors de la chambre (702) sensiblement sous la forme d'une vapeur, la chambre (702) comportant une structure dans la chambre (702) qui empêche le blocage de l'orifice de sortie (727) lorsque la chambre (702) est soumise à des orientations défavorables comprenant un passage de vapeur (704) en communication fluidique avec l'orifice de sortie (721), le passage de vapeur (704) comprenant une première voie de passage de fluide (713) et une deuxième voie de passage de fluide (714) chacune en communication fluidique avec la chambre (702), et un dispositif (708) pouvant être utilisé pour fermer de manière sélective l'une de la première voie de passage de fluide (713) et de la deuxième voie de passage de fluide (714) en fonction d'une orientation de la chambre (702) ;
amener le fluide de refroidissement en communication thermique avec la structure générant de la chaleur dans le canal, la chaleur provenant de la structure générant de la chaleur amenant le fluide de refroidissement sous la forme d'un liquide à bouillir et à se vaporiser dans le canal de sorte que le fluide de refroidissement absorbe la chaleur provenant de la structure générant de la chaleur alors que le fluide de refroidissement change d'état ; et
fermer de manière sélective l'une de la première voie de passage de fluide (713) et de la deuxième voie de passage de fluide (714) en fonction d'une orientation de la chambre (702) et permettre à la vapeur de sortir à travers l'autre de la première voie de passage de fluide (713) et de la deuxième voie de passage de fluide (714).

10. Procédé selon la revendication 9, consistant en outre à :
réduire une pression du fluide de refroidissement à une pression sub-atmosphérique à laquelle le fluide de refroidissement a une température d'ébullition inférieure à une température de la structure générant de la chaleur.

11. Procédé selon la revendication 9 ou la revendication 10, consistant en outre à :
diriger un écoulement du fluide de refroidissement sous la forme d'un liquide dans la chambre (702) à travers l'orifice d'entrée (725), dans lequel la chaleur provenant de la structure générant de la chaleur amène le fluide de refroidissement sous la forme d'un liquide à bouillir et à se vaporiser dans la chambre (702) de sorte que le fluide de refroidissement absorbe la chaleur provenant de la structure générant de la chaleur (12) alors que le fluide de refroidissement change d'état.

12. Procédé selon l'une quelconque des revendications 9 à 11, consistant en outre à :
retirer l'air qui s'infiltre dans la chambre (702).
